# EUROPEAN PATENT APPLICATION

(11) **EP 2 239 767 A1**
(43) Date of publication of application: **13.10.2010**
(21) Application number: 09100231.1
(22) Date of filing: 08.04.2009
(51) Int. Cl.: H01L 21/60, H01L 23/538

(54) **Package for a semiconductor die and method of making the same**

(71) Applicant: NXP B.V., 5656 AG Eindhoven (NL)
(72) Inventor: Peels, W.G. M., Redhill, Surrey RH1 1DL (GB); van der Lugt, Anthonie, Redhill, Surrey RH1 1DL (GB)
(74) Representative: Williamson, Paul Lewis

(57) **Abstract**

The present invention relates to a package (24) for a die (2,4) comprising an intermediate product (2,6,8) used for producing the package (24), the intermediate product (2,6,8) comprising a lead frame (6) having at least one pre-defined position (2e) for the die (2,4), characterized by a rim (18) for at least partly surrounding the at least one pre-defined position (2e). A method is also provided of applying solderable material to said pre-defined position, soldering the die to said pre-defined position on said lead frame, laminating insulating material (10) to said lead frame, the insulating material having a cavity at said pre-defined position to accommodate the die, laminating a foil (14,16) thereto and providing interconnects though said foil (14,16) to electrodes (2c,d;4c,d) on said die and through the insulating material (10) to said lead frame (6).

## Description

### FIELD OF THE INVENTION

The present invention generally relates to a method for producing a package for a die, and to the resulting package.

### BACKGROUND OF THE INVENTION

WO 2005/104636 Al discloses an electronics module and a method for manufacturing the same. The electronics module of this prior art includes at least one component embedded in an insulating-material layer, which has a first contacting surface, in which there are first contact terminals, from which the component is connected electrically to the conductor structures contained in the electronics module. In addition, the component of this prior art document has a second contacting surface opposite to the first contacting surface. This second contacting surface comprises at least one second contact terminal, from which the component is connected electrically to the conductors structures contained in the electronics module.

This prior art document further discusses a method for making a package for a component. In a first stage of that method, a metal layer is provided and holes are introduced into the layer. In a second stage an adhesive is provided on the layer with the holes. Then in a third stage there is provided the component which is set in place above the holes in the metal layer and pressed into the adhesive by using the aid of an assembly machine. However, it turns out difficult to make the package at a large scale. Both the step of positioning the die and the step of laminating the insulating material to the metal layer turn out to give alignment problems.

### SUMMARY OF THE INVENTION

It is an object of the present invention to provide an improved method for producing a package for a die, in particular for a power component.

In a first aspect of the present invention a method for producing a package for a die, in particular for a power component, is presented that comprises the steps of:
- providing a foil (6), with at least one pre-defined position (2e) for the die (2, 4),
- at least partly surrounding the at least one pre-defined position (2e) with a rim (18);
- applying a solderable material to at least one pre-defined position (2e)..
- providing the die (2, 4),
- soldering the die (2, 4) to the pre-defined position on the foil (6) to connect the die (2, 4) to the foil (6),
- laminating the foil with insulating material, a width of the rim defining a minimum distance between the die and the insulating material;
- using at least a part of the foil (6) as at least a part of an interconnection to an opposite side (2c, 4c) of the die (2, 4).

In another aspect, a packaged die is provided, wherein the die is present in a cavity within insulating material that is laminated with a first and a second foil on opposite sides of the die, the first foil being electrically conductive and soldered to the die and patterned to form part of an interconnection to the opposite side, electrically conductive contacts with externally exposed terminal surfaces extending through the second foil and the insulating material to the die and to the first foil, wherein a rim is present on the first foil that surrounds the die and defines a distance between the die and the insulating material.

The method and the package of the invention defines improvements that allow their application to the field of discrete and semi-discrete semiconductor products. Typical subdomain thereof include the domain of the general application devices, hereinafter also referred to as GA-dies, and the domain of power devices, hereinafter also referred to as PM-devices. The dies of the present invention may include vertical devices such as bipolar transistors or diodes with contacts to the bottom side

A key feature of the invention is the application of a rim at the conductive foil around the predefined area for the die. This rim is beneficial for various reasons, that all need attention in the present application area. First of all, it is achieved with the rim that the dies are self-aligned, without creation placement problems that the die - or some of a plurality of dies - does not fit the predefined location. The self-alignment occurs after placement, in a heating step needed to establish the solder connection. In this heating step, at least part of the solder melts, which leads to self-alignment. The rim is therein necessary, in order to limit the spread of solder. In other words: without rim no chance of using solder, and without solder no self-alignment of die and foil. Suitably, in that respect, the rim comprises a solder resist or solder stop material.

Secondly, the rim defines a minimum distance between the die and the insulating material to be laminated around the die. Such distance is needed. PM-devices tend to warm up considerably during use. A direct contact between die and insulating material, typically a prepeg, might well lead to deformations and reliability problems. The space between die and insulating material effectively acts as a thermal isolator and serves to ensure that excessive heat leaves to die through the soldered connection to the conductive foil. The conductive foil can be coupled to a heat sink, a heat pipe or another heat removal and/or heat dissipation element to ensure sufficient heat removal and/or heat storage. GA-devices tend to have less thermal problems, but need to be very small. Here, the rim supports the necessary alignment during assembly - not only because of mechanical alignment, but also because the prevention of spread of adhesive or solder can be exploited to reduce the dimensions of design rules. Moreover, certain GA-devices are in use for ESD-protection. In that case it is important that the generated heat and current can be led away efficiently in a predefined direction.

Suitably, the die is provided with a pre-applied solder layer on its bottom side that is to be soldered to the conductive foil. This facilitates an effective assembly process. Suitably, though not necessarily, the solder layer is applied in a patterned manner, e.g. as one or more dots per die. This patterned application allows an even more efficient assembly; the dots will be used to contact the foil, such that the die does not need to fit immediately within the frame of the solder rim. The die will find its final position only in the heating step. An additional advantage of such patterned application of the solder layer on the bottom side of the die is that the amount of solder can be reduced: no solder is applied in separation lanes between individual dies on a wafer.

The provision of discrete devices in packages that are partially based on printed circuit board technology further allows the integration of inductors and/or other elements into the package. It moreover allows to provide interconnection between individual dies integrated in the package. These dies could be the same dies, but could alternatively different dies, put together so as to fulfill a desired function in an optimal manner.

According to a preferred embodiment of the invention, preferably to be used for general application (GA) dies or devices, i.e., small signal devices, the bottom of the die which is to be attached to the foil can comprise AuGe.

Basically the solder used for the present invention can be any solder or solderable material. But in preferred embodiments of the present invention the soldering step or the solder can comprise leadfree solder. Alternatively the soldering step or the solder can comprise high PbSn (Ag) reflow soldering or solder. This is in particular suitable for medium power dies or devices and, but can also be used for small signal dies or devices. Additionally or alternatively the bottom of the die to be attached to the foil can comprise any solderable material, preferably a solderable conductive material, more preferably a material comprising metal, even more preferably TiNiAg or NiAu or similar compositions. The solder can comprise an organic solder.

In another preferred embodiment the for the method or the package can comprise Cu. Additionally or alternatively the foil can be plated with Ag-spots at places which are preferably located at the pre-defined locations on the foil which are intended to come into contact with the dies to be attached to the foil. The finish can be any solderable finish, preferably substantially bare copper.

In another preferred embodiment of the method for producing a package for a die at least a part of the foil can be used as at least a part of a interconnection to an opposite side of the die. So if the foil is a bottom foil which is to be connected to the bottom of the die, at least a part of the bottom foil can be used as at least a part of an interconnection from the top side of the die to the bottom side of the die connected to the bottom foil.

In another preferred embodiment of the present invention at least a part of the foil can be used as a ground-, power- and/or signal- plane for at least one further die component and/or heat pipe which further die component and/or heat pipe can be attached to the foil in such an embodiment.

In another preferred embodiment of the present invention it is used or provided a die which carries a plating which preferably comprises Cu on the other side of it, i.e., the side opposite the side to be connected to the foil, e.g., the bottom foil.

### DETAILED DESCRIPTION OF THE INVENTION

The present invention is further elucidated by the following figures and examples, which are not intended to limit the scope of the invention. The person skilled in the art will understand that various embodiments may be combined.

### BRIEF DESCRIPTION OF THE DRAWINGS

These and other aspects of the invention will be apparent from and elucidated with reference to the embodiment(s) described hereinafter. In the following drawings
Fig. 1 shows a schematic illustration of a first embodiment of the present invention; and
Fig. 2 shows a schematic illustration of process steps of a second embodiment of the present invention.

### DETAILED DESCRIPTION OF THE DRAWINGS

The components in the drawings are not necessarly to scale, emphasize instead being placed upon clearly illustrating the principles of the present invention. Features that are substantially or functionally equal or similiar will be refered to with the same reference sign(s).

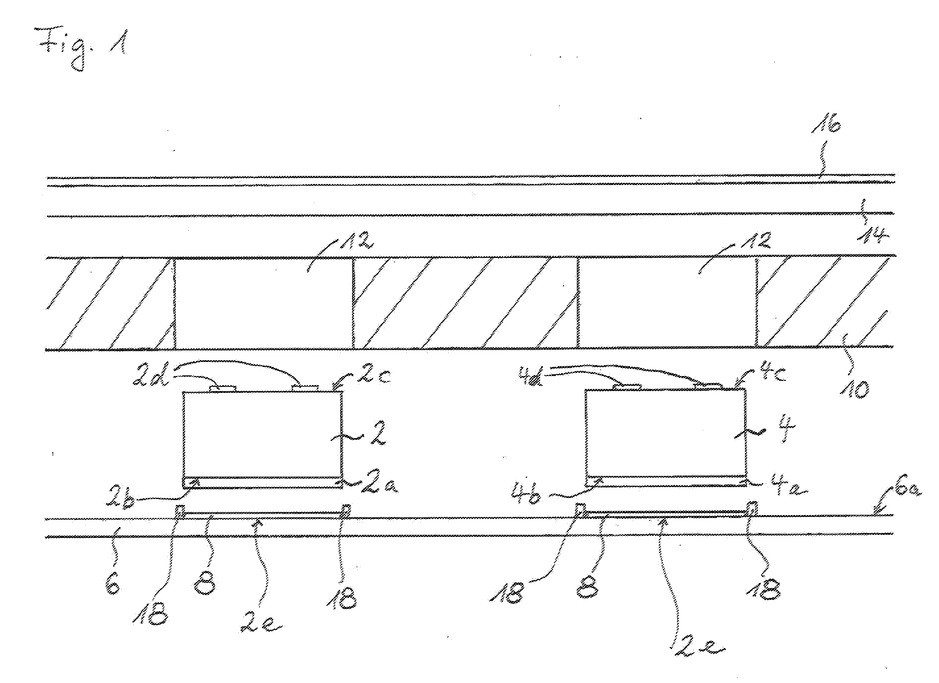

Figure 1 shows a schematic illustration of a first embodiment of the present invention. In the drawing it is depicted on the left hand side of the drawing a GA-die 2 and on the right hand side of the drawing a PM-die 4. Die 2 comes with a pre-applied solder layer 2a on a bottom side 2b of the die 2. Pre-applied solder layer 2a contains AuGe. Furthermore die 2 carries on its top side 2c opposite its bottom side 2b Cu-platings 2d.

PM-die 4 carries on its bottom side 4b a pre-applied solder layer 4a. Solder layer 4a comprises TiNiAg. On its top side 4c opposite its bottom side 4b die 4 carries also Cu-platings 4d.

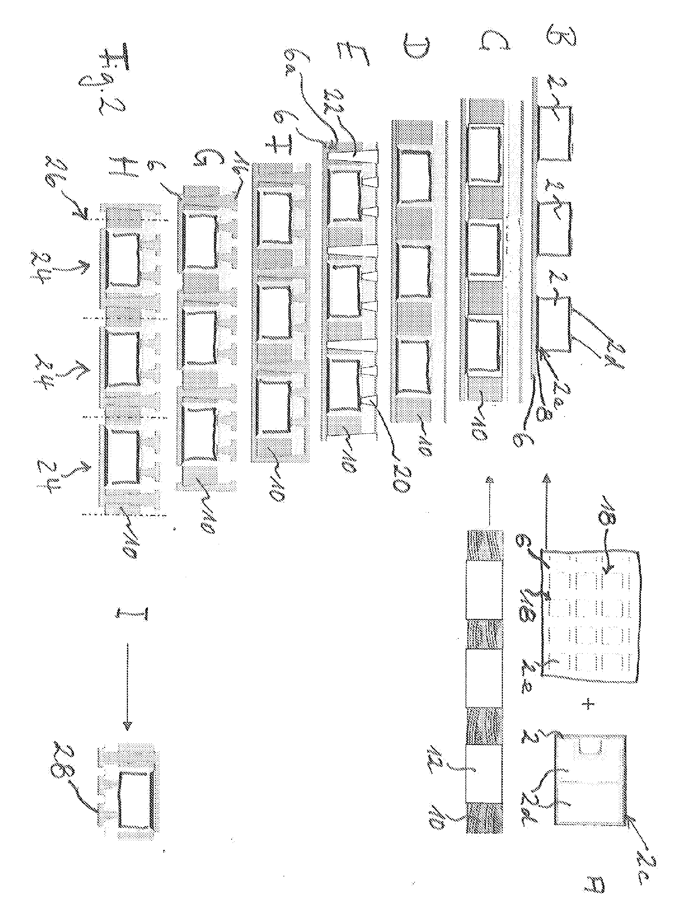

As shown in figure 1 power dies 4 and general application dies 2 can be integrated into one product or package 24 (see figure 2) build up at least of those parts shown in the drawing of figure 1.

In the drawing of figure 1 it is shown below dies 2 and 4 a Cu-foil 6 on which Ag-spots 8 are plated on the top side of bottom foil 6 which top side faces bottom sides 2b and 4b of dies 2 and 4, respectively.

Figure 1 shows the - first - foil 6 being a lead frame for the dies 2, 4. Foil 6 has pre-defined positions 2e for each die 2, 4. Around each pre-defined position 2e there is provided a substantially rectangular rim 18 for surrounding the pre-defined positions 2e. Each rim 18 surrounds the pre-defined positions 2e in a way that a closed frame 18 is created in a size which is substantially the same as a footprint of the dies 2, 4 for the respective pre-defined position 2e.

Furthermore figure 1 shows a pre-punched or pre-drilled prepreg 10. Prepreg 10 contains openings 12 sized to accomodate dies 2 and 4, respectively.

Furthermore figure 1 shows a - second - RCC-foil which carries a Cu-layer 16.

Figure 2 shows an illustration main process steps of an embodiment of the present invention. In stage A a die 2 is depicted in a top view carrying Cu-platings 2d on its top side 2c. Die 2 is carried by a Cu-foil 6 indicated by the "+" symbol in stage A. Die 2 also carries on its bottom side 2b (as shown in figure 1) a solder layer 2a (as shown in figure 1).

As shown in stage B a number of dies 2 is attached or connected to Ag-spots 8 on Cu-foil 6 by soldering the pre-applied solder layer 2a of die 2 to the Ag-spots 8 on Cu-foil 6 serving as a bottom metal foil for the package 24 to be produced by the embodiment as shown in figure 2. Alternatively or additionally a number of dies 2 and/or 4 can be attached or connected to a solderable area 8 on Cu-foil 6 applying solder or solder paste by screen printing, dispensing, dipping or other application methods inside each frame 18 so that the solder remains inside the frame 18 which acts as a solder resist frame 18, because when the solder melts its flow is limited by the frame 18. In this way the self alignment effect of the dies 2 and/or 4 on top of molten solder can be used to guarantee good alignment of the dies 2 and/or 4 on the lead frame 6. Again the foil 6 serves as a bottom metal foil for the package 24 to be produced by the embodiment as shown in figure 2.

In stage C a pre-drilled and pre-punched prepreg 10 with holes 12 is provided and overlayed over the intermediate product 2, 6, 8 of stage B to accomodate dies 2 in openings 12 of prepreg 10. Then also in stage C an RCC-foil 14 carrying a Cu-layer 16 is layed on top of the combination of prepreg 10 and the intermediate product 2, 6, 8 of stage B.

In stage D this performed a vacuum lamination to laminate RCC-foil 16 and prepreg 10 to dies 2.

In stage E it is performed a laser drilling of holes 20 to Cu-platings 2d of dies 2 and a laser drilling - performed in parallel or serial to the aforementioned laser drilling - of holes 22 all the way through layer 16, foil 14, preprag 10 down to the surface 6a of bottom foil 6.

In stage F it is performed an electroplating to fill holes 20 and 22.

In stage G it is performed a photo-etch to provide a desired structure into layer 16 and layer 6.

In stage H it is performed a separation of each of the produced packages 24 which separation is indicated by dashed lines 26.

Additionally it can be performed a flip in stage I to provide a flipped package 28.

While the invention has been illustrated and described in detail in the drawings and foregoing description, such illustration and description are to be considered illustrative or exemplary and not restrictive; the invention is not limited to the disclosed embodiments.

Other variations to the disclosed embodiments can be understood and effected by those skilled in the art in practicing the claimed invention, from a study of the drawings, the disclosure, and the appended claims.

In the claims, the word "comprising" does not exclude other elements or steps, and the indefinite article "a" or "an" does not exclude a plurality. A single die, component, package, intermediate product or other unit may fulfill the functions of several items recited in the claims. The mere fact that certain measures are recited in mutually different dependent claims does not indicate that a combination of these measured cannot be used to advantage.

Any reference signs in the claims should not be construed as limiting the scope.

## Claims

1. A method for producing a package (24) for a die (2, 4), comprising the method of anyone of claims 1 - 3:
- providing a foil (6), with at least one pre-defined position (2e) for the die (2, 4),
- at least partly surrounding the at least one pre-defined position (2e) with a rim (18);
- applying a solderable material to at least one pre-defined position (2e)..
- providing the die (2, 4),
- soldering the die (2, 4) to the pre-defined position on the foil (6) to connect the die (2, 4) to the foil (6),
- laminating the foil with insulating material, a width of the rim defining a minimum distance between the die and the insulating material;
- using at least a part of the foil (6) as at least a part of an interconnection to an opposite side (2c, 4c) of the die (2, 4).

2. A method as claimed in Claim 1, wherein the rim (18) is provided in a way that an at least partly closed frame (18) is created in a size which is substantially the same as a footprint of the die (2, 4) for that at least one pre-defined position (2e).

3. A method as claimed in Claim 1, further comprising the steps of providing contacts from the opposite side to contact surfaces of the die and to the foil.

4. A method as claimed in Claim 1, wherein the step of using the foil as interconnection comprises the step of patterning the foil, so as to remove the foil at scribe lanes between individual dies.

5. The method as claimed in Claim 1, wherein the insulating material comprises prepeg material conventionally applied in printed circuit boards.

6. A method as claimed in Claim 1, wherein the die comprises a discrete or semidiscrete semiconductor device with a back-side contact surface.

7. A method as claimed in Claim 1, wherein the bottom surface of the die comprises a pre-applied solder layer.

8. A packaged die, wherein the die is present in a cavity within insulating material that is laminated with a first and a second foil on opposite sides of the die, the first foil being electrically conductive and soldered to the die and patterned to form part of an interconnection to the opposite side, electrically conductive contacts with externally exposed terminal surfaces extending through the second foil and the insulating material to the die and to the first foil, wherein a rim is present on the first foil that surrounds the die and defines a distance between the die and the insulating material.
